## Europäisches Patentamt

## European Patent Office

## Office européen des brevets

(19)

(11) Veröffentlichungsnummer: **0 182 264**
**B1**

(12) **EUROPÄISCHE PATENTSCHRIFT**

(45) Veröffentlichungstag der Patentschrift:
03.02.88

(51) Int. Cl.⁴: **B 65 D 25/10, B 65 D 85/00**

(21) Anmeldenummer: **85114388.3**

(22) Anmeldetag: **12.11.85**

(54) Horde für Halb- und Fertigprodukte.

(30) Priorität: **13.11.84 DE 3441483**

(43) Veröffentlichungstag der Anmeldung:
**28.05.86 Patentblatt 86/22**

(45) Bekanntmachung des Hinweises auf die Patenterteilung:
**03.02.88 Patentblatt 88/5**

(84) Benannte Vertragsstaaten:
**AT BE CH DE FR GB IT LI NL SE**

(56) Entgegenhaltungen:
**US-A-3 915 307**
**US-A-3 966 043**

(73) Patentinhaber: **Siemens Aktiengesellschaft Berlin und München, Wittelsbacherplatz 2, D-8000 München 2 (DE)**

(72) Erfinder: **Vötter, Max, Hufschmiedstrasse 3, D-8081 Malching (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1988

## Beschreibung

Die Erfindung betrifft eine Horde für Halb- und Fertigprodukte, insbesondere für elektrische Stiftspulenkörper mit am einen Spulenkörperflansch befestigten Spulenkörperstiften und für mit diesen Spulenkörpern bestückte Spulen, die sowohl als Transporthorde für die Halbprodukte z. B. Stiftspulenkörper als auch als Verpackungshorde für die Fertigprodukte, z. B. Spulen einsetzbar und als Profilschiene mit dem Produkt in etwa angepaßtem tunnelartigem Querschnitt ausgebildet ist.

Bisher war es üblich, daß der Hersteller der elektrischen Stiftspulenkörper die Spulenkörper vorwiegend auf plattenförmige Schaumstoffe auf Kunststoffbasis, wie z. B. Polystyrol gesteckt, in Kartons verpackt und so an den Abnehmer, d.h. an den Hersteller elektrischer Spulen gesandt hat. Abnehmerseitig wurden dabei die Stiftspulenkörper manuell von den Schaumstoffträgern abgezogen und manuell oder mit Rund- oder Linearförderern auf die Spulenwickelmmaschine gesteckt und nach ihrer Bewicklung und Lötung mittels je nach Spulenhersteller unterschiedlichsten Transporteinrichtungen und entsprechend angepaßten Ablagereinrichtungen zu den Montageeinrichtungen befördert. Die fertig montierten elektrischen Spulen wurden schließlich in eigens hierfür bestimmten Verpackungen an den Kunden verschickt.

Der vorliegenden Erfindung liegt die Aufgabe zugrunde, eine Horde zu schaffen, die für Halb- und Fertigprodukte und zwar insbesondere für den Transport elektrischer Stiftspulenkörper von Bearbeitungsmaschine zu Bearbeitungsmaschine und zusätzlich auch für die Verpackung der fertig bewickelten und gelöteten Spule geeignet ist. Diese als Transport- und Verpackungshorde verwendbare Horde soll darüberhinaus die Spulenkörper, nämlich vorwiegend Stiftspulenkörper mit angespitzten Anschlußstiften, vor Beschädigung schützen, und insbesondere auch Stiftverbiegungen, Stiftausbrüche und Brüche der Spulenkörperflansche, verursacht durch unsachgemäßen Transport, verhindern.

Zur Lösung dieser Aufgabe sieht die Erfindung bei einer Horde der eingangs genannten Art vor, daß die lichte Höhe (a) der Profilschiene gleich bzw. geringfügig größer als die Höhe (b) des Fertigproduktes gewählt ist, die durch Einschieben eines Streifens, z. B. Pappkartonstreifens, auf die Höhe des Halbproduktes reduzierbar ist.

Diese Horde ist in einfachster Weise an die unterschiedlichen Höhen der Halb- und Fertigprodukte angleichbar. Hierzu bedarf es lediglich des Einschubs bzw. des Herausziehens des Streifens. Diese Horde zeichnet sich zusätzlich durch eine ausgezeichnete Führung der in der Horde befindlichen Teile aus. Bei Verwendung einer Horde mit allseitig geschlossener Profilschiene kann zudem die Wandstärke der Profilschiene erheblich verringert und trotzdem eine große Formstabilität der Horde bei Verwindungsbeanspruchung aufrecht erhalten werden.

Zum Einschieben des Streifens in die Profilschiene weisen die Seitenwände der Profilschiene in geeignetem Abstand zum Bodenteil Führungsschienen auf, die als Stege ausgebildet sein können, die an die seitlichen Innenwände der Profilschiene angeformt sind.

Die Führungsschienen sind dabei in einem Abstand zum Bodenteil der Profilschiene angeordnet, welcher etwa der Differenz der Höhen des Fertig- und Halbprodukts entspricht.

Zur Stapelung mehrerer Horden ist die zum Bodenteil abgekehrte Seitenfläche jeder Profilschiene bevorzugt mit einer Ausnehmung ausgebildet, in der jeweils die folgende Profilschiene mittels ihres Bodenteils geführt ist. Dieser Art ist eine einwandfreie, formstabilisierende Stapelung der Horden möglich.

Die vorstehend beschriebene Horde ist als Verpackung z. B. für unbewickelte Spulenkörper und für fertige Spulen, aber auch für ähnlich gestaltete elektrische Bauelemente und Zubehörteile zu diesen Bauelementen gleichermaßen geeignet und ersetzt als Werkstückträger aufwendige und typengebundene Zuführungen und Maschineneinrichtungen. Die Horde ist, z. B. bei ihrem Einsatz für Spulenkörper und fertige Spulen, bei entsprechender Gestaltung der Horde und der Zuführung zum Wickelautomaten ohne Zwischenschaltung mehrerer Elemente auf den Wickelautomaten aufsteckbar, so daß eine unmittelbare Entnahme der Spulenkörper erfolgen kann. Ein ansonsten dem Wickelautomaten vorangesetztes aufwendiges und nicht variables Zuführsystem für die Spulenkörper, wie z. B. ein Rund- oder Linearförderer entfällt dadurch. Die gleiche Horde kann die bereits gewickelten und gelöteten Spulenkörper wieder aufnehmen, d.h. die Horde kann auch als Werkstückträger zwischen der Wickel- und der ihr nachgeschalteten Spulen - Montage dienen. Nach Beendigung der Spulenmontage können die fertigen Spulen gleichfalls und zwar nach Entnahme des Streifens aus der Horde in die gleichen Horden eingefügt und nach Verpackung in Kartons in den Versand gegeben werden.

Die Erfindung wird nachstehend anhand eines Ausführungsbeispieles näher erläutert. Es zeigt:
Fig. 1 eine Horde nach der Erfindung in Stirnansicht und in vergrößertem Maßstab,
Fig. 2 die Horde nach Fig. 1 in der Darstellung nach Fig. 1 jedoch mit eingesetzten Stiftspulenkörpern,
Fig. 3 die Horde nach Fig. 1, 2 in der Darstellung nach Fig. 2, jedoch mit in der Horde gelagerter fertiger Spule.

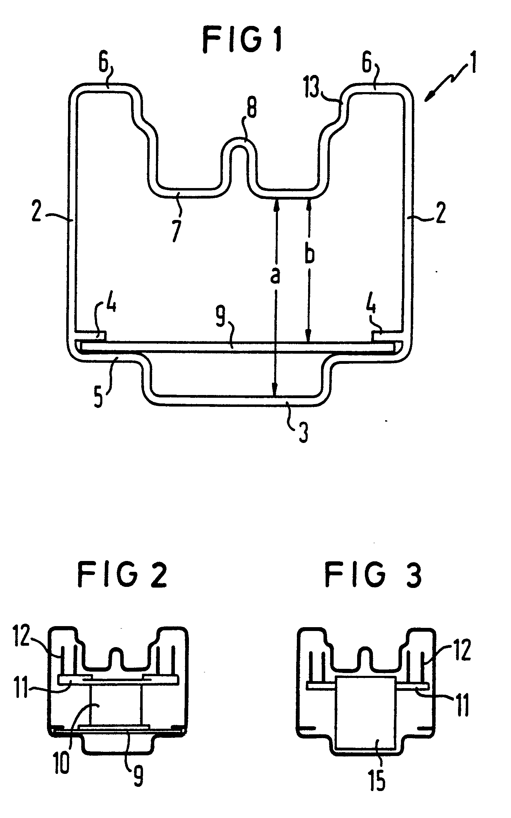

Die Horde nach Fig. 1 bis 3 ist als Profilschiene 1 mit tunnelartigem Querschnitt ausgebildet, der bevorzugt dem Halb- bzw. Fertigprodukt, z. B. dem in Fig. 2 gezeigten Stiftspulenkörper 10 bzw. der in Fig. 3 dargestellten fertigen elektrischen Spule 15 angepaßt ist. Die lichte Höhe a der Profilschiene 1, d.h. der Abstand zwischen dem Bodenteil 3 und der hierzu gegenüberliegenden Seitenfläche 7 ist dabei gleich bzw. geringfügig größer als die Höhe des Fertigprodukts, nämlich der elektrischen Spule 15 gewählt. Durch Einschieben eines Streifens 9, z. B. eines Pappkartonstreifens in entsprechende Führungsschienen 4, 5 läßt sich die vorerwähnte Höhe auf die Höhe "b" des Halbproduktes, nämlich des Stiftspulenkörpers 10 verringern.

Die Führungsschienen können als Stege ausgebildet sein, die an die Seitenwände 2 angeformt sind. Denkbar ist auch - wie dies in Fig. 1 bis 3 gezeigt ist - daß die einen Elemente der Führungsschienen als Stege 4 ausgebildet sind und die anderen Elemente dieser Führungsschienen durch die Bodenteile 5 gebildet werden, die durch stufenförmige Verjüngung des Bodenteils 3 entstehen.

Zur Aufnahme der in die Spulenkörperflansche 11 eingelassenen Spulenkörperstifte 12 weist die Seitenfläche 7 der Profilschiene 1 Vertiefungen 6,6 auf. Eine zusätzliche Vertiefung 8 kann darüberhinaus als weiteres Führungselement für die elektrische Spule bzw. elektrischen Spulenkörper dienen.

Zur Stapelung mehrerer Horden ist die zum Bodenteil 3 abgekehrte Seitenfläche jeder Profilschiene 1 mit Ausnehmungen 13 ausgebildet in denen jeweils die folgende Profilschiene 1 mittels ihres Bodenteils 3 geführt ist. Hierdurch wird eine mechanisch feste, insbesondere verschiebesichere Stapelung gewährleistet.

## Patentansprüche

1. Horde für Halb- und Fertigprodukte, insbesondere für elektrische Stiftspulenkörper mit am einen Spulenkörperflansch befestigten Spulenkörperstiften und für mit diesen Spulenkörpern bestückte Spulen, die sowohl als Transporthorde für die Halbprodukte (Stiftspulenkörper) als auch als Verpackungshorde für die Fertigprodukte (Spulen) einsetzbar und als Profilschiene mit dem Produkt in etwa angepaßtem tunnelartigem Querschnitt ausgebildet ist, dadurch gekennzeichnet, daß die lichte Höhe (a) der Profilschiene (1) gleich bzw. geringfügig größer als die Höhe des Fertigproduktes (15) gewählt ist, die durch Einschieben eines Streifens (9) auf die Höhe (b) des Halbproduktes (10) reduzierbar ist.

2. Horde nach Anspruch 1, dadurch gekennzeichnet, daß die Seitenwände (2,2) der Profilschiene (1) in geeignetem Abstand zum Bodenteil (3) Führungsschienen (4, 5) zur Führung des insbesondere aus Isolierstoff bestehenden Streifens (9) aufweisen.

3. Horde nach Anspruch 1, dadurch gekennzeichnet, daß die Führungsschienen (4, 5) als Stege ausgebildet sind, die an die seitlichen Innenwände der Profilschiene (1) angeformt sind.

4. Horde nach Anspruch 1, 2 und 3, dadurch gekennzeichnet, daß die Führungsschienen (4, 5) in einem Abstand zum Bodenteil (3) angeordnet sind, welcher etwa der Differenz der Höhen (a bzw. b) des Fertig- und Halbprodukts entspricht.

5. Horde nach Anspruch 1, dadurch gekennzeichnet, daß die zum Bodenteil (3) abgekehrten Seitenfläche (7) der Profilschiene (1) Vertiefungen (6,6) zur Aufnahme der Spulenkörperstifte (12) von Stiftspulenkörpern (10) aufweist.

6. Horde nach Anspruch 1 und einem der vorhergehenden Ansprüche, dadurch gekennzeichnet, daß das Bodenteil (3) in seinen zu den Seitenwänden (2) gekehrten Teilen stufenförmig abgesetzt ist und diese Stufen Teile der Führungsschienen (4, 5) bilden.

7. Horde nach Anspruch 1, dadurch gekennzeichnet, daß zur Stapelung mehrerer Horden die zum Bodenteil (3) abgekehrte Seitenfläche jeder Profilschiene (1) mit einer Ausnehmung (13) ausgebildet ist, in der jeweils die folgende Profilschiene (1) mittels ihres Bodenteils (3) geführt ist.

## Claims

1. A hurdle for semi-finished and finished products, particularly for pinned electrical bobbin forms with bobbin pins fastened onto one bobbin flange and for bobbins fitted with these bobbin forms, which can be used as a transport hurdle for the semi-finished products (pinned bobbin forms) as well as a packing hurdle for the finished products (bobbins) and is constructed as a profile strip with a tunnel-like cross-section approximately adapted to the product, characterised in that the unobstructed height (a) of the profile strip (1) is selected to be the same, or slightly greater than the height of the finished product (15), and can be reduced to the height (b) of the semi-finished product (10) by inserting a strip (9).

2. A hurdle as claimed in Claim 1, characterised in that the side-walls (2,2) of the profile strip (1) have guide rails (4,5) at a suitable distance from the floor-piece (3), for guiding the strip (9), which consists particularly of insulating material.

3. A hurdle as claimed in Claim 1, characterised in that the guide rails (4,5) are formed as ledges which are moulded onto the interior side-walls of the profile strip (1).

4. A hurdle as claimed in Claims 1, 2 and 3, characterised in that the guide rails (4,5) are positioned at a distance from the floorpiece (3) which approximately corresponds to the difference between the heights (a and b) of the finished and semi-finished products.

5. A hurdle as claimed in Claim 1, characterised in that the side-surface (7) of the profile strip (1) which facee the floor-piece (3) has recesses (6,6) for receiving the bobbin form pins (12) of the pinned bobbin forms (10).

6. A hurdle as claimed in Claim 1 and one of the previous Claims, characterised in that the floor-piece (3) is recessed so as to have steps, in its parts adjacent the side-walls (2), and these steps form parts of the guide rails (4,5).

7. A hurdle as claimed in Claim 1, characterised in that for stacking several hurdles, the side-surface of each profile strip (1), which faces the floor-piece (3), is formed with an indentation (13), in which each following profile strip (1) can be fitted by means of its floor-piece (3).

**Claims**

1. Claie pour produits finis et semi-finis, notamment pour des carcasses de bobines électriques à broches, ayant des broches de carcasse de bobine fixées à une joue de la carcasse de bobine et pour des bobines munies de ces carcasses de bobine, qui peut être utilisée à la fois comme claie de transport pour les produits semi-finis (carcasses de bobine à broches) et comme claie d'emballage des produits finis (bobines) et qui est constituée d'une barre profilée de section transversale en forme de tunnel sensiblement adaptée au produit, caractérisée en ce que la hauteur libre (a) de la barre profilée est égale ou légèrement supérieure à la hauteur du produit fini (15) et peut être réduite à la hauteur (b) du produit semi-fini par l'introduction d'une bande (9).

2. Claie suivant la revendication 1, caractérisée en ce que les parois latérales (2, 2) de la barre profilée (1) comportent, à une distance convenable de la partie formant le fond (3), des barres de guidage (4, 5) pour guider la bande (9) constituée notamment en matière isolante.

3. Claie suivant la revendication 1, caractérisée en ce que les barres de guidage (4, 5) sont constituées sous la forme de nervures issues des parois latérales intérieures de la barre profilée (1).

4. Claie suivant la revendication 1, 2 ou 3, caractérisée en ce que les barres de guidage (4, 5) sont disposées à une distance de la partie formant le fond (3), qui correspond à peu près à la différence de hauteur (a et b) entre le produit fini et le produit semi-fini.

5. Claie suivant la revendication 1, caractérisée en ce que les surfaces latérales (7) de la barre profilée (1), qui sont éloignées de la partie formant le fond (3), comportent des évidements (6, 6) de réception des broches (12) des carcasses de bobine à broches (10).

6. Claie suivant la revendication 1 ou l'une des revendications précédentes, caractérisée en ce que les parties du fond (3) tournées vers les parois latérales (2) sont en retrait sous forme d'épaulements et ces épaulements forment des parties des barres de guidage (4, 5).

7. Claie suivant la revendication 1, caractérisée en ce que, pour empiler plusieurs claies, les surfaces latérales de chaque barre profilée (1), qui sont éloignées de la partie formant le fond (3) sont constituées en ayant une partie creuse (13) dans laquelle la barre profilée (1) suivante est guidée au moyen de sa partie formant le fond (3).

# FIG 1

# FIG 2

# FIG 3